# EUROPEAN PATENT APPLICATION

(11) **EP 3 319 220 A1**
(43) Date of publication of application: **09.05.2018**
(21) Application number: 17199532.7
(22) Date of filing: 01.11.2017
(51) Int. Cl.: H02N 2/18, H01L 41/113, E04F 11/104

(54) **DEFORMABLE ELECTRICAL GENERATOR FOR ENERGY HARVESTING**

(30) Priority: 02.11.2016 GB 201618486; 30.06.2017 GB 201710533
(71) Applicant: Altro Limited, Letchworth Garden City Hertfordshire SG6 1NW (GB)
(72) Inventor: PEACE, Richard John, Letchworth, Hertfordshire SG6 1NW (GB); PATSAVELLAS, Ioannis, Letchworth, Hertfordshire SG6 1NW (GB); PUSCASU, Onoriu, Letchworth, Hertfordshire SG6 1NW (GB); HERFATMANESH, Mohammad Reza, Hatfield, Hertfordshire AL10 9AB (GB); DAY, Rodney, Hatfield, Hertfordshire AL10 9AB (GB)
(74) Representative: Peel, James Peter

(57) **Abstract**

The proposed energy generator comprises an energy harvesting material (19) which generates electrical energy when deformed from a first position to a second position and one or more deflection aids comprising a moveable clamp (93), wherein each deflection aid biases the harvesting material to the first position, the generator preferably forming a flexible piezoelectric bistable bending element. An energy harvesting system and a floor covering, for example a step nosing, comprising at least one such generator are also disclosed.

## Description

The present invention provides an electrical energy generator, an electrical energy harvesting layer for use in a floor covering, a synthetic floor covering comprising the electrical energy harvesting layer and an electrical energy harvesting system, particularly an electrical energy harvesting flooring system.

With the desire to add sensors and other features to existing buildings or other locations where there is no power supply, there is a need to find ways to generate electrical energy at such locations. Electrical energy generators are known but the energy generated by them is not predictable which makes them difficult to use. Fitting power cabling is expensive and using batteries requires replacement of the batteries when they run out or recharging them, either of which is an expensive and complex task as the number of devices increases.

The manufacture of synthetic floor coverings is an energy intensive process. Accordingly, there is a need to reduce the carbon footprint of synthetic floor coverings. Indeed, there is a growing need for new buildings to be carbon neutral such that the carbon dioxide generated in their construction may be offset by the building generating renewable energy for example from solar panels or wind turbines. Other sources of energy have been sought to increase the rate at which new buildings become carbon neutral.

A way of ameliorating these problems has been sought.

According to the invention there is provided an energy generator comprising an energy harvesting material which generates energy when deformed or moved from a first position to a second position wherein the energy generator comprises one or more deflection aids wherein each deflection aid biases the energy harvesting material to the first position.

According to the invention there is provided an energy generator comprising an energy harvesting material which generates energy when moved from a pre-selected first position to a second position wherein the energy generator comprises one or more deflection aids which comprise a moveable clamp wherein each deflection aid biases the energy harvesting material to the first position and wherein the first position of the energy harvesting material is pre-selected using the moveable clamp.

According to the invention there is provided an energy harvesting layer for use in a flooring material wherein the energy harvesting layer comprises one or more energy generators according to the invention.

According to the invention, there is also provided an energy harvesting floor covering which comprises a layer of synthetic material and one or more energy generators according to the invention and/or an energy harvesting layer according to the invention.

According to the invention there is further provided an energy harvesting system comprising (a) an energy generator according to the invention, an energy harvesting layer according to the invention and/or the energy harvesting flooring material according to the invention; (b) a power management circuit and (c) an electrical storage device.

The advantages of the deflection aid being moveable from a first to a second position include that by limiting the movement of the energy generators used in the flooring material to movement between two pre-defined positions, the lifetime of the energy harvesting flooring material is enhanced because the movement can be controlled and the amount of electrical energy generated per unit area of flooring can be more easily predicted, allowing informed decisions to be made about the electrical systems to be used with the energy generator.

In some embodiments, each energy generator includes at least one electrode; for example the energy generator may comprise an upper electrode and a lower electrode which are respectively arranged above and below the energy harvesting material. In some embodiments, an electrode for use in the energy generator may be formed from a flexible conductive material such as a metal sheet (e.g. copper or aluminium), a conductive polymer, a conductive ink or a metal coated polymer.

In some embodiments, the deflection aid biases the energy harvesting material to its first position. In some embodiments, the energy generator includes a deflection aid in the form of a buffer to deflect the energy harvesting material to its first position when pressure on the energy generator is released. In some embodiments, the buffer deflection aid may be formed from a resilient material such as a foamed material. In some embodiments, the buffer deflection aid may be shaped to support the energy harvesting layer in its first position.

In some embodiments, the energy generator may comprise a deflection aid in the form of an energy generator support which has a moveable clamp and a support wall between which the energy harvesting material may be clamped in the first position. In some embodiments, the energy generator may comprise a flexible energy harvesting material which comprises a flexible upper electrode, a layer of piezoelectric material and a resilient lower electrode wherein the layer of piezoelectric material is arranged between the upper and lower electrodes. In some embodiments, the resilient lower electrode may be in the form of a rigid conductive support. The energy generator support is a deflection aid because it has been found that when the energy generator support clamps the flexible energy harvesting material in the first position, the flexible energy harvesting material is biased to the first position. This is believed to be particularly because piezoelectric material has a different shape and mechanical properties from the resilient lower electrode. As a result, it is more difficult to bend the flexible energy harvesting material downwards than upwards, making the first position which has a convex shape a state of lower potential energy, and thus a state of rest. It has surprisingly been found that by using a flexible energy harvesting material and a deflection aid in the form of an energy generator support, the energy generator may be more compact such that its energy generation is about three to four times greater per unit area than that of an energy harvesting material having a bistable deflection aid. The flexible energy harvesting material is also less noisy in operation.

In some embodiments, the energy generator support may have one or more clamp rails to guide the movement of the moveable clamp. In some embodiments, the energy generator support may have a clamp control to control the movement of the moveable clamp such that the deflection aid is an adjustable deflection aid. In some embodiments, the moveable clamp and support wall of the energy generator support may have resilient material on their inner surfaces to engage the energy harvesting material.

In some embodiments, the energy generator may comprise a bistable deflection aid having two stable orientations which are a first resting orientation and a second orientation into which the bistable deflection aid may be deflected. Advantages of such a bistable deflection aid includes that they can enhance efficiency of the energy harvesting flooring material because a small force may generate a big movement such that more energy is generated and that the energy harvesting material is not deformed but is displaced. Using a bistable deflection aid, efficiency may be increased by a factor of four or five. In some embodiments, the bistable deflection aid may comprise a sprung or pressed element; for example formed from a resilient material such as a metal (e.g. brass, copper or aluminium) or a metal coated polymer having a sufficient thickness that when pressed into shape, it becomes bistable. A skilled person would be familiar with materials suitable for this purpose. In some embodiments, the bistable deflection aid may also function as an electrode; for example the upper and/or lower electrode for the energy generator may be bistable deflection aids.

In some embodiments, the energy harvesting layer may comprise one or more conductive materials for connecting the energy generators. The energy harvesting layer may comprise a layer of conductive material, for example a layer of a metal or of a conductive polymeric material or adhesive, for example a layer of aluminium, copper or conductive phenolic resin. In some embodiments, the conductive material may comprise a conductive ink. In some embodiments, the layer of conductive material may be a printed layer, for example a screen printed layer or a digital inkjet printed layer.

In some embodiments, the energy generating flooring may include a deflection aid. In some embodiments, the deflection aid may comprise one or more studs on a lower surface of the layer of synthetic material of the flooring material according to the invention. In some embodiments, each of the one or more studs may be aligned with each of the one or more energy generators. In some embodiments, where the deflection aid comprises one or more studs, the energy harvesting material may be a stretchable material; for example an elastic material.

In some embodiments, the energy harvesting system according to the invention may be an energy harvesting flooring system comprising a flooring material or floor covering. Examples of an energy harvesting flooring system include a step nosing for mounting on the front edge of a step. A step nosing is an easy way to retrofit the system to a building. In some embodiments, a step nosing may include a light fitting. In this way, a step nosing according to the invention may provide a green solution to the problem of providing emergency lighting to a staircase. In some embodiments, the step nosing may include a sensor such as a light sensor and/or a presence sensor. Advantages of such sensors include that the lighting only operates on when needed. In some embodiments, the sensor may be linked to a fire alarm for emergency use.

In some embodiments, the energy harvesting system may comprise a plurality of step nosings for mounting on a flight of steps, a control module and an energy storage wherein the step nosings are operably connected to the control module and energy storage. In some embodiments, the control module may be programmed to illuminate the flight of steps in the direction of travel by a user.

In some embodiments, a step nosing according to the invention may include a housing for receiving the energy harvesting layer according to the invention, power management circuit and electrical storage device. In some embodiments, the step nosing according to the invention may have a cover. In some embodiments, the cover may be in the form of an extrusion or formed from a resilient material such as rubber, glass reinforced plastic or PVC resin.

In some embodiments, the power management circuit may be any electrical system suitable for operating the energy harvesting system. For example, the power management circuit may be suitable for transforming the electrical energy generated by the energy generators into a form suitable for storage in the electrical storage device and/or the power management circuit may be suitable for managing the use of the stored electrical energy. In some embodiments, the power management circuit may include a system such as a rectifier for converting the variable voltage output of the energy harvesting system into a continuous DC voltage to charge a battery or to supply a circuit.

In some embodiments, the electrical storage device may be any device known to a skilled person to be suitable for storing electrical energy generated by the energy harvesting system. For example the electrical storage device may be a battery, capacitor or a super-capacitor.

In some embodiments, the energy harvesting layer or generator comprises an electroactive polymer, an electret and/or a piezoelectric material.

Examples of electroactive polymers include a dielectric electroactive polymer such as a dielectric elastomer, a ferroelectric polymer such as PVDF, an electrostrictive graft polymer and/or a liquid crystalline polymer such as a natural or synthetic piezoelectric material. Examples of electrets include a ferroelectret, a real-charge electret and/or an oriented-dipole electret; for example an electret formed from a synthetic polymer such as a fluoropolymer, polypropylene and/or polyethyleneterephthalate. Examples of ferroelectrets include one or more layers of a cellular polymer or polymer foam formed from a polymer such as polycarbonate, perfluorinated or partially fluorinated polymers such as PTFE, fluoroethylenepropylene (FEP), perfluoroalkoxyethylenes (PFA), polypropylene, polyesters, polyethylene terephthalate (PET), polyethylene naphthalate (PEN), cyclo-olefin polymers, cyclo-olefin copolymers, polyimides, polymethyl methacrylate (PMMA) and/or polymer blends.

Examples of suitable piezoelectric materials include a natural material (for example silk) or a synthetic material (such as a polymeric and/or ceramic material). A suitable piezoelectric polymer includes a semi-crystalline polymer or an amorphous dipolar polymer. Suitable semi-crystalline piezoelectric polymers include polyvinylidene fluoride (PVDF), a PVDF copolymer (such as polyvinylidene fluoride tetrafluoroethylene (PVDF-TrFE)) or terpolymer (such as polyvinylidene fluoride tetrafluoroethylene chlorotrifluoroethylene (PVDF-TrFE-CTFE)), polyamides, liquid crystal polymers and/or poly(p-xylylene) (such as Parylene-C). Suitable amorphous dipolar piezoelectric polymers include polyimide and/or polyvinylidene chloride.

A suitable ceramic piezoelectric material includes a particle of lead titanate such as lead zirconate titanate (PZT) or PMT-PT, lead potassium niobate, sodium potassium niobate (NKN), bismuth ferrite, sodium niobate, bismuth titanate, sodium bismuth titanate, barium titanate, potassium niobate, lithium niobate, lithium tantalite, sodium tungstate, zinc oxide and/or barium sodium niobate. In some embodiments, the ceramic material may be in the form of a particle. In some embodiments, the piezoelectric layer may comprise one or more polymer layers wherein one or more of the polymer layers comprise a particle of piezoelectric ceramic material.

In some embodiments, the energy harvesting layer may comprise a resilient layer. The resilient layer may be arranged under the one or more energy generators. In some embodiments, the resilient layer may comprise a lattice-shaped support forming spaces. In some embodiments, the one or more deflection aids may be aligned with the spaces of the lattice-shaped support. This is in order that the resilient material of the resilient layer may assist returning the one or more energy generators to their original position after the removal of pressure on the flooring material.

In some embodiments, the energy harvesting layer may comprise a protective layer. The protective layer may be an insulating protective layer. In some embodiments, the energy harvesting layer may comprise one or more layers of energy generators.

In some embodiments, the energy harvesting system comprises an electrically powered device to be powered by the electrical storage device. Examples of suitable electrically powered devices include a sensor, a lighting system and/or an alarm system.

In some embodiments, the electrical storage device may be provided in the energy harvesting system or in a wall or ceiling, particularly an adjacent wall or ceiling or in a lower wall area such as skirting or coving.

In some embodiments, the flooring material comprises a protective coating layer. The protective coating layer may be a chemically protective coating layer or an upper layer of a conventional flooring such as a layer of matting, natural or synthetic carpet, ceramic, wood, cork, rubber or stone. Where the protective coating layer is a chemically protective coating layer, the protective coating layer may be thermally curable (e.g. water-based polyurethane or PVDF), a thermally and/or UV curable (e.g. water-based UV curable polyurethane) layer or a UV curable (e.g. a polyacrylate or urethane acrylate) layer.

In some embodiments, the flooring material may be a non-slip flooring material. In some embodiments, the flooring material may comprise a non-slip protective coating layer. A non-slip protective coating layer may comprise one or more non-slip particles. In some embodiments, the particles may be smooth particles. A smooth particle is a particle which has no angular protrusion or indentation, for example a particle which has no protrusion or indentation having an outward facing angle of about 90° or less. In some embodiments, the particles may be one or more of a smooth sphere, bead and grain. The advantage of using a smooth particle in the composition or flooring material according to the invention is that the cured coating is easier to clean as the coating lacks any angular surface in which a cleaning material (for example the fibres of a mop) may be caught.

In some embodiments, a non-slip particle used in the flooring material according to the invention may be one or more of the following types of particle: a glass particle, a silica particle, a polymeric particle (for example Nylon (Trademark)), a ceramic particle (e.g. porcelain) and an aluminium oxide particle. In some embodiments from 15 to 70 weight % of non-slip particle may be used relative to the weight of the materials used to form the layer in which the non-slip particle is included.

In some embodiments, the protective coating layer may include one or more layers. Where the non-slip protective coating layer has two or more layers such that the non-slip protective coating layer has an upper coating layer which provides the non-slip surface and one or more lower coating layers, at least the upper coating layer contains non-slip particles.

In some embodiments, the flooring material used in the invention comprises one or more undercoat layers comprising a plastics material, for example a polymeric material. Examples of suitable plastics material include plasticised PVC, rubber, rubber and a polyolefin, linoleum, plasticised acrylic, and/or a polyolefin. Optionally, the one or more undercoat layers may contain one or more types of slip resistant and/or wear resistant particles such as aluminium oxide, silicon carbide, quartz or glass. Optionally, the one or more undercoat layers may include one or more types of decorative elements such as a coloured chip, fleck and/or flake for example of a coloured polymeric material and/or a printed decorative layer. The flooring material may optionally be embossed.

In some embodiments, a flooring material comprising rubber and a polyolefin may comprise a thermoplastic polymer and an elastomer material. In some embodiments, a thermoplastic polymer may be a polyethylene (for example ultra high molecular weight polyethylene or an ethylene alkane copolymer), an acid copolymer, an ionomer, polystyrene, acrylate (for example ethylene butyl acrylate or ethylene methyl acrylate), acetate (for example ethylene vinyl acetate), PVC, polypropylene and/or polybutylene. In some embodiments, an elastomer may be styrene butadiene rubber, nitrile butadiene rubber, natural rubber, isoprene rubber and/or ethylene propylene rubber. In some embodiments, the flooring material comprising rubber and a polyolefin may additionally comprise a production additive such as a friction reducer for example a silicone. In some embodiments, the flooring material comprising rubber and a polyolefin may additionally comprise a top protective layer of a polyurethane, acrylate, epoxy or a mixture thereof. A suitable flooring material comprising rubber and a polyolefin is disclosed in US2008/053335, the contents of which document is incorporated herein by reference.

In some embodiments, the flooring material comprises a decorative layer. A decorative layer may be a layer of ink or a printed film layer.

The energy harvesting flooring system is generally suitable for use in a building, particularly a building having high footfall such as a municipal building such as a hospital, a library, a court house, a theatre, a shopping centre or mall. Alternatively, the energy harvesting flooring system may be suitable for use in part of a building having high footfall, such as a stairwell. The energy harvesting flooring system is also generally suitable for use in a vehicle, particularly a transit vehicle such as a bus, train, aeroplane or ship (for example a ferry).

In some embodiments, the energy harvesting flooring system may comprise an energy harvesting flooring material having one or more harvesting areas suitable for placement in a zone of high footfall where the energy harvesting layer comprises a piezoelectric material, optionally one or more conducting areas where the energy harvesting layer comprises a conductive material for connecting the harvesting area to the power management system and optionally one or more neutral areas where the energy harvesting layer is a non-conductive layer of synthetic material.

In some embodiments, the energy harvesting system may include a wireless transmitter (for example a radio transmitter) such that the energy harvesting system may be used as a remote control (for example for blinds, curtains, air conditioning, gates and/or doors), a sensor (for example an impact or force detector or presence sensor) or a switch (for example for a light switch or doorbell). In some embodiments, the energy harvesting system may be a wireless light switch containing an energy generator and a radio transmitter (could be embedded into a wall or floor).

The invention will now be described with reference to the following Figures of the accompanying drawings which are not intended to limit the scope of the invention in which:
**Figure 1** shows a schematic cross-section of a first embodiment of an energy generator according to the invention;
**Figure 2** shows a schematic cross-section of a second embodiment of an energy generator according to the invention;
**Figure 3** shows a schematic cross-section of a third embodiment of an energy generator according to the invention;
**Figure 4** shows a schematic cross-section of a fourth embodiment of an energy generator according to the invention;
**Figure 5** shows a schematic cross-section of a fifth embodiment of an energy generator according to the invention;
**Figure 6** shows a schematic cross-section of a sixth embodiment of an energy generator according to the invention;
**Figure 7** shows a schematic cross-section of a first embodiment of an energy harvesting layer according to the invention for use in a flooring material;
**Figure 8** shows a schematic cross-section of a second embodiment of an energy harvesting layer according to the invention for use in a flooring material;
**Figure 9** shows a schematic cross-section of a first embodiment of a flooring material according to the invention which is in the form of an underlay and a decorative floor covering having a profiled base layer;
**Figure 10** shows a schematic underneath plan view of the first embodiment of a flooring material according to the invention shown in Figure 9;
**Figure 11** shows a schematic cross-section of a second embodiment of a flooring material according to the invention which is in the form of an underlay and a decorative floor covering having a profiled base layer;
**Figure 12** shows a schematic overhead plan view of a first embodiment of an energy harvesting flooring system according to the invention;
**Figure 13** shows a schematic overhead plan view of a second embodiment of an energy harvesting flooring system according to the invention;
**Figure 14** shows a schematic cross-section longitudinal view of a third embodiment of a flooring material according to the invention;
**Figure 15** shows a schematic cross-section view of a flight of steps using the energy harvesting flooring system according to the invention;
**Figure 16** shows a schematic cross-sectional view of a first embodiment of an energy harvesting system according to the invention;
**Figure 17** shows a schematic plan view of a seventh embodiment of an energy generator according to the invention;
**Figure 18** shows a schematic cross-sectional view of the seventh embodiment of the energy generator according to the invention;
**Figure 19** shows a schematic cross-sectional view of an eighth embodiment of an energy generator according to the invention;
**Figure 20** shows a schematic cross-sectional view of a flexible energy harvesting material for use in the invention;
**Figure 21** shows a schematic cross-sectional view of fifth embodiment of an energy harvesting flooring system according to the invention;
**Figure 22** shows a schematic cross-sectional view of a second embodiment of an energy harvesting system according to the invention; and
**Figure 23** shows a schematic cross-sectional view of a fifth embodiment of an energy harvesting flooring system according to the invention.

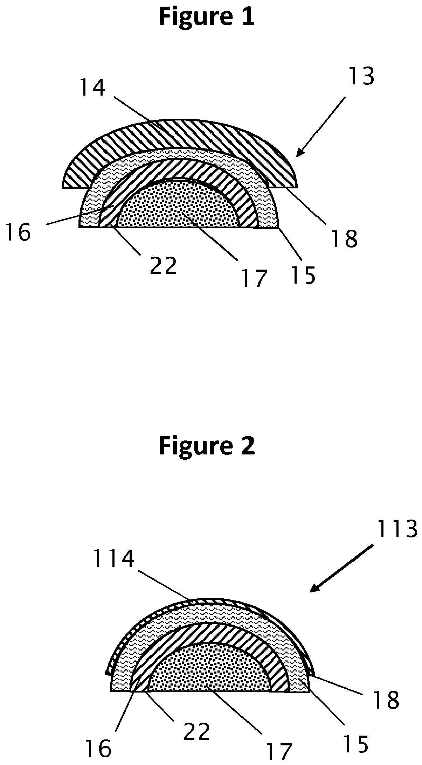

A first embodiment of an energy generator is indicated generally at 13 on Figure 1. The energy generator 13 has four layers which comprise a curved bistable upper electrode 14, a curved energy harvesting material layer 15, a curved bistable lower electrode 16 and a dome-shaped buffer of resilient material 17 wherein the energy harvesting material layer 15 is arranged between the curved upper electrode 14 and the curved lower electrode 16.

Bistable upper and lower electrodes 14,16 are each a pressed element formed by pressing or stamping a resilient conductive material such as a metal (e.g. brass, copper or aluminium) or a metal coated polymer such that they have a curved shape. Bistable upper electrode 14 is shaped such that its lower ends 18 are spaced from the lower ends 22 of the lower electrode 16 to prevent a short circuit in use. Being pressed into a curved shape, the upper and lower electrodes 14,16 are bistable such that they have two stable orientations which are a first convex resting orientation and a second concave orientation. The bistable upper and lower electrodes 14,16 may be moved from their first orientation to their second orientation on the application of force but when the force is removed, the upper and lower electrodes 14,16 deflect back to their first orientation because of their pressed shape and of the resilience of the material used to form them. Thus the bistable upper and lower electrodes 14,16 are deflection aids. Accordingly the bistable upper and lower electrodes 14,16 resiliently bias the energy generator 13 into a first convex arch-shaped position as depicted in Figure 1. The dome-shaped buffer 17 supports the energy generator 13 in its first position. On the application of force on the energy generator 13, the energy generator 13 moves into a second concave U-shaped position (not shown). When such application of force stops, the energy generator 13 resiliently returns to its first convex position, deflected by the bistable upper and lower electrodes 14,16 and the buffer of resilient material 17. The bistable upper and lower electrodes 14,16 and buffer 17 thus form deflection aids.

A second embodiment of an energy generator is indicated generally at 113 on Figure 2. The energy generator 113 has four layers which comprise a flexible upper electrode 114 , an energy harvesting material layer 15, a curved bistable lower electrode 16 and a dome-shaped buffer of resilient material 17 wherein the energy harvesting material layer 15 is arranged between the upper electrode 114 and the lower electrode 16.

Flexible upper electrode 114 is formed from a flexible conductive material such as a metal (e.g. brass, copper or aluminium), a conductive polymer, ink or a metal coated polymer. Bistable lower electrode 16 is a pressed element formed by pressing or stamping a resilient conductive material such as a metal (e.g. brass, copper or aluminium) or a metal coated polymer. Flexible upper electrode 114 is shaped such that its lower ends 18 are spaced from the lower ends 22 of the bistable lower electrode 16 to prevent a short circuit in use. Being pressed into a curved shape, the lower electrode 16 is bistable such that it has two stable orientations which are a first convex resting orientation and a second concave orientation. The bistable lower electrode 16 may be moved from its first orientation to its second orientation on the application of force but when the force is removed, the bistable lower electrode 16 deflects back to its first orientation because of its pressed shape and of the resilience of its material. Thus the bistable lower electrode 16 is a deflection aid. Accordingly the bistable lower electrode 16 resiliently biases the energy generator 113 into a first arch-shaped convex position as depicted in Figure 2. The dome-shaped buffer 17 supports the energy generator 113 in its first position. On application of force, the energy generator 113 moves into a second U-shaped concave position (not shown). When such application of force stops, the energy generator 113 resiliently returns to its first convex position, deflected by the pressed shape of bistable lower electrode 16 and the buffer of resilient material 17. The bistable lower electrode 16 and buffer 17 thus form deflection aids.

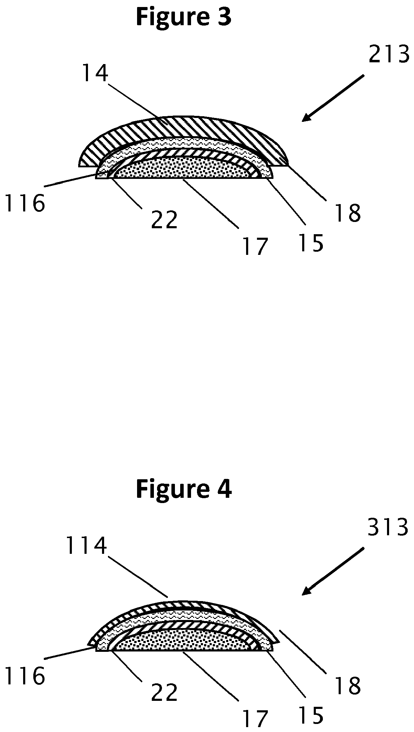

A third embodiment of an energy generator is indicated generally at 213 on Figure 3. The energy generator 213 has four layers which comprise a bistable upper electrode 14, an energy harvesting material layer 15, a flexible lower electrode 116 and a dome-shaped buffer of resilient material 17 wherein the energy harvesting material layer 15 is arranged between the bistable upper electrode 14 and the flexible lower electrode 116.

Flexible lower electrode 116 is formed from a flexible conductive material such as a metal (e.g. brass, copper or aluminium), a conductive polymer, ink or a metal coated polymer. Bistable upper electrode 14 is a pressed element formed by pressing or stamping a resilient conductive material such as a metal (e.g. brass, copper or aluminium) or a metal coated polymer. Bistable upper electrode 14 is shaped such that its lower ends 18 are spaced from the lower ends 22 of the lower electrode 116 to prevent a short circuit in use. Being pressed into a curved shape, the upper electrode 14 is bistable such that it has two stable orientations which are a first convex resting orientation and a second concave orientation. The bistable upper electrode 14 may be moved from its first orientation to its second orientation on the application of force but when the force is removed, the upper electrode 14 deflects back to its first orientation because of its pressed shape and of the resilience of its material. Thus the upper electrode 14 is a deflection aid. Accordingly the lower electrode 14 resiliently biases the energy generator 213 into a first arch-shaped convex position as depicted in Figure 3. The dome-shaped buffer 17 supports the energy generator 213 in its first position. Application of force on the energy generator 213 causes it to be deflected into a second U-shaped concave position (not shown). When such application of force stops, each energy generator 213 resiliently returns to its first convex position, biased by the pressed shape of upper electrode 14 and by the buffer of resilient material 17. The upper electrode 14 and buffer 17 thus form deflection aids.

A fourth embodiment of an energy generator is indicated generally at 313 on Figure 4. The energy generator 313 has four layers which comprise an upper electrode 114, an energy harvesting material layer 15, a lower electrode 116 and a dome-shaped buffer of resilient material 17 wherein the energy harvesting material layer 15 is arranged between the upper electrode 114 and the lower electrode 116.

Flexible upper and lower electrodes 114,116 are formed from a flexible conductive material such as a metal (e.g. brass, copper or aluminium), conductive polymer, ink or a metal coated polymer. Flexible upper electrode 114 is shaped such that its lower ends 18 are spaced from the lower ends 22 of the flexible lower electrode 116 to prevent a short circuit in use. Being biased into a curved shape by buffer 17, the energy generator 313 is initially in a first arch-shaped convex position as depicted in Figure 4. Application of force on the energy generator 313 causes it to be moved into a second U-shaped concave position (not shown). When such application of force stops, the energy generator 313 resiliently returns to its first position, deflected by the buffer of resilient material 17. The buffer 17 thus forms a deflection aid.

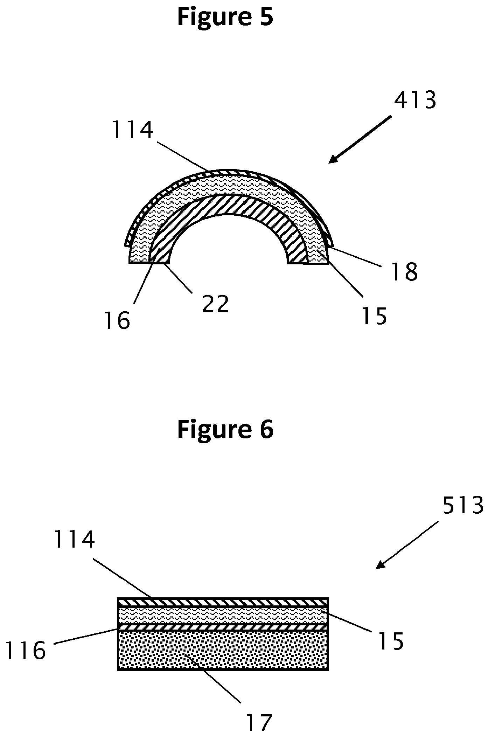

A fifth embodiment of an energy generator is indicated generally at 413 on Figure 5. The energy generator 413 has three layers which comprise a flexible upper electrode 114 , an energy harvesting material layer 15 and a bistable lower electrode 16 wherein the energy harvesting material layer 15 is arranged between the flexible upper electrode 114 and the bistable lower electrode 16.

Flexible upper electrode 114 is formed from a flexible conductive material such as a metal (e.g. brass, copper or aluminium), a conductive polymer, ink or a metal coated polymer. Bistable lower electrode 16 is a pressed element formed by pressing or stamping a resilient conductive material such as a metal (e.g. brass, copper or aluminium) or a metal coated polymer. Flexible upper electrode 114 is shaped such that its lower ends 18 are spaced from the lower ends 22 of the bistable lower electrode 16 to prevent a short circuit in use. Being pressed into a curved shape, the bistable lower electrode 16 is bistable such that it has two stable orientations which are a first convex resting orientation and a second concave orientation. The bistable lower electrode 16 may be moved from its first orientation to its second orientation on the application of force but when the force is removed, the lower electrode 16 deflects back to its first orientation because of its pressed shape and of the resilience of its material. Thus the bistable lower electrode 16 is a deflection aid. Accordingly the lower electrode 16 resiliently biases the energy generator 413 into a first arch-shaped convex position as depicted in Figure 5. On application of force, the energy generator 413 moves into a second U-shaped concave position (not shown). When such application of force stops, the energy generator 413 resiliently returns to its first convex position, deflected by the pressed shape of lower electrode 16. The lower electrode 16 thus forms a deflection aid. In an alternative embodiment, the energy generator 413 may have a bistable upper electrode and a flexible lower electrode. In an alternative embodiment, the energy generator may have a bistable upper electrode and a bistable lower electrode.

A sixth embodiment of an energy generator is indicated generally at 513 on Figure 6. The energy generator 513 has four layers which comprise a flexible upper electrode 114, an energy harvesting material layer 15, a flexible lower electrode 116 and a block-shaped buffer of resilient material 17 wherein the energy harvesting material layer 15 is arranged between the upper electrode 114 and the lower electrode 116.

Flexible upper and lower electrodes 114,116 are formed from a flexible conductive material such as a metal (e.g. brass, copper or aluminium), conductive polymer, ink or a metal coated polymer. Flexible upper and lower electrodes 114,116 are shaped as flat layers. Upper and lower electrodes 114,116 and energy harvesting layer 15 may be formed from a resilient stretchable material to allow such deflection or may be loosely arranged such that there is sufficient slack in the electrodes 114,116 and energy harvesting layer 115 to allow for the deflection. Application of force on the energy generator 313 causes it to be moved into a U-shaped concave position (not shown). When such application of force stops, the energy generator 513 resiliently returns to its first position, deflected by the buffer of resilient material 17. The buffer 17 thus forms a deflection aid. Compared with the energy generator 313, energy generator 513 has a lesser degree of deflection and so has a small power output.

By the energy generators 13,113,213,413 having a bi-stable arrangement comprising one or more deflection aids having a pressed element, the efficiency of the energy generation is increased as a small force results in a large deflection. The efficiency may be increased by a factor of 4 to 5 times. Furthermore the energy generators 13,113,213,313,413,513 generate a pre-determined amount of electrical energy because the degree of deflection of the energy harvesting material layer 15 is known. In an alternative embodiment, the amount of energy generated by the energy generators 13,113,213,313,413,513 may be pre-selected by determining the degree of deflection of the energy harvesting layer 15 by appropriate selection of the shape and/or materials used to form the electrodes 14,114,16,116 and the buffer layer 17. In an alternative embodiment, the energy generators 13,113,213,313,413,513 may include an upper and lower conductive element (not shown) suitable for connecting the energy generator to a power management system and/or to an electrical storage device.

The energy harvesting material layer 15 may be formed from a suitable material which generates electrical energy when it is displaced or deformed such as electroactive polymer, an electret and/or a piezoelectric material. Where the energy harvesting material is capable of generating electrical energy without the need for electrodes, the energy generator 113,213,313,413,513 may omit the flexible upper and/or lower electrodes 114,116.

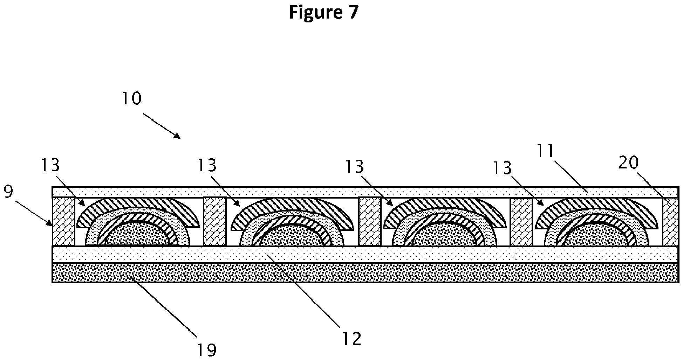

A first embodiment of an energy harvesting layer according to the invention is indicated generally at 10 on Figure 7. The energy harvesting layer 10 comprises an upper layer of conductive elements 11, a lower layer of conductive elements 12, an energy generator layer 9 comprising a plurality of energy generators 13 according to the first embodiment of the invention which are spaced apart by an insulator 20 and a layer of resilient material 19. In an alternate embodiment, the layer of resilient material 19 may be omitted.

The upper and lower conductive layers 11,12 are for collecting the generated energy and for applying a voltage to the electrodes 14,16. The upper conductive layer 11 comprises a matrix of conductive elements (not shown) arranged to connect the upper electrodes 14 of the energy generators 13. The lower conductive layer 12 comprises a matrix of conductive elements (not shown) arranged to connect the lower electrodes 16 of the energy generators 13. In some embodiments, the conductive elements (not shown) of the upper and lower conductive layers 11,12 may be printed on the conductive layers.

The plurality of energy generators 13 are arranged as a matrix in at least one row in a horizontal layer 9 which is positioned below the upper conductive layer 11 and above the lower conductive layer 12. In an alternative embodiment, one or more of the energy generators 13 according to the first embodiment may be replaced by one or more energy generators 113 according to the second embodiment and/or one or more energy generators 213 according to the third embodiment and/or one or more energy generators 313 according to the fourth embodiment and/or one or more energy generators 413 according to the fifth embodiment and/or one or more energy generators 513 according to the sixth embodiment.

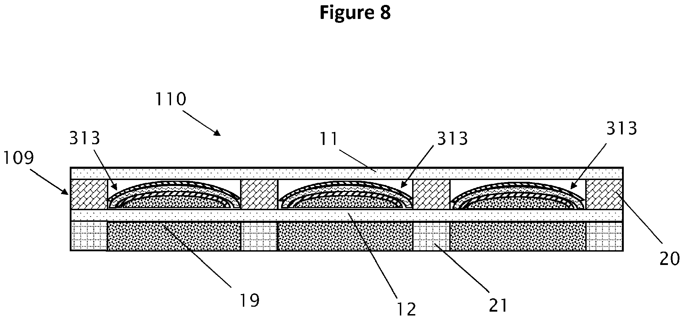

A second embodiment of an energy harvesting layer according to the invention for use in a flooring material is indicated generally at 110 is illustrated in Figure 8. Like parts of the second embodiment of an energy harvesting layer 110 to the parts of the first embodiment of an energy harvesting layer 10 have been identified with a like reference numeral. The energy harvesting layer 110 comprises an upper layer of conductive elements 11, a lower layer of conductive elements 12, a plurality of energy generators according to a fourth embodiment of the invention which are indicated generally at 313, an insulator 20 which is arranged between each energy generator 313 and a resilient layer 19. The energy generators 313 and insulators 20 are arranged in a row 109 in series between the upper and lower layers of conductive elements 11,12. The resilient layer 19 comprises energy harvesting layer supports 21. The supports 21 are arranged such that each support 21 align with an insulator 20. In use, when a force or pressure is applied to the upper surface of the energy harvesting layer 110, one or more energy generators 313 are deflected downwards from their first positions to their second positions where each energy generator 313 engages with and compresses the resilient layer 19. On removal of the force or pressure, resilient layer 19 assists returning each energy generator 313 to its first position. In an alternative embodiment, one or more energy generators 313 according to the fourth embodiment may be replaced by one or more of the energy generators 13 according to the first embodiment and/or by one or more energy generators 113 according to the second embodiment and/or by one or more energy generators 213 according to the third embodiment and/or one or more energy generators 413 according to the fifth embodiment and/or one or more energy generators 513 according to the sixth embodiment.

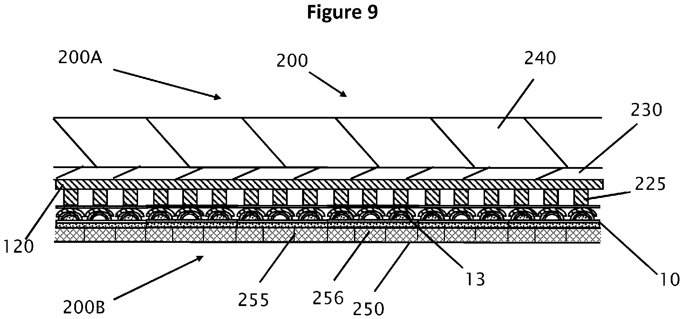

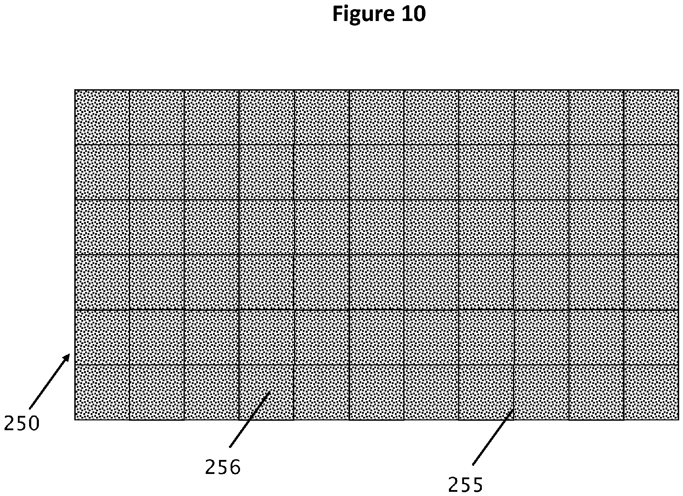

The first embodiment of a flooring material indicated generally at 200 is illustrated in Figures 9 and 10. Flooring material 200 comprises a decorative flooring material indicated generally at 200A and an energy generating underlay 200B.

Energy generating underlay 200B has two layers laminated or adhered together and is an underlay for placing underneath a conventional flooring material. A first lower layer is a deformable layer indicated generally at 250 in Figure 10. Deformable layer 250 has a lattice-shaped support structure 255 which forms lattice spaces 256. The support 255 provides the energy generating underlay 200B with a degree of structure. As the deformable layer 250 is suitable for use in sound attenuation, it needs the support 255 to reduce rolling resistance. It has been found that such a deformable acoustic layer 250 is so deformable that it has a rolling resistance which makes it difficult to roll trolleys or other wheeled objects on it without support 255. On top of the deformable layer 250, there is an energy harvesting layer 10 as illustrated in Figure 7 comprising a plurality of dome-shaped energy generators according to the first embodiment of the invention 13. Each energy generator 13 is arranged to align with a space 256 in lattice-shaped support structure 255. The energy harvesting layer 10 may be laminated or adhered to the deformable layer 250. In an alternative embodiment, energy harvesting underlay 200B has a protective layer on top of the energy harvesting layer 10. The deformable layer 250 may be formed from rubber crumb, rubber and polyolefin and/or a plastics material with a blowing agent such as blown PVC. The support 255 may be formed from a resilient plastics or metal such as polycarbonate or aluminium. In an alternative embodiment, one or more of the energy generators 13 according to the first embodiment may be replaced by one or more energy generators 113 according to the second embodiment and/or one or more energy generators 213 according to the third embodiment and/or one or more energy generators 313 according to the fourth embodiment and/or one or more energy generators 413 according to the fifth embodiment and/or one or more energy generators 513 according to the sixth embodiment.

Floor covering 200A has a decorative upper layer 240, an intermediate scrim layer 210 and a lower layer 220 having a lower surface which is provided with studs or profiles 225 which act as deflection aids. In use, the floor covering 200A is placed on the energy harvesting underlay 200B such that the studs or profiles 225 ensure maximum deflection of the energy harvesting layer 10 when a person walks on floor covering 200A by aligning each stud or profile 225 with a dome-shaped energy generator 13 of the energy harvesting layer 10. Floor covering 200A may be a floor covering as disclosed in WO 03/106783, the contents of which document is incorporated herein by reference.

In an alternative embodiment, the energy harvesting layer 10 may be replaced with an energy harvesting layer 110 according to the second embodiment of the invention. In such an embodiment, each stud or profile 225 is aligned with an energy generator 313. As an alternative embodiment, the flooring material 200 may have more than one energy harvesting layer 10,110.

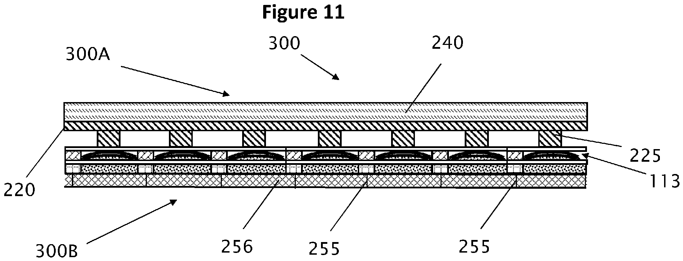

A second embodiment of a flooring material according to the invention indicated generally at 300 is illustrated in Figure 11. Flooring material 300 comprises a decorative flooring material indicated generally at 300A and an energy generating underlay 300B. Energy generating underlay 300B has two layers laminated or adhered together and is an underlay for placing underneath a conventional flooring material. A first layer is a deformable layer 250 having a lattice-shaped support structure 255 which forms lattice spaces 256, as shown in Figure 10. On top of the deformable layer 250, there is an energy harvesting layer 110 according to the second embodiment as illustrated in Figure 8 comprising a plurality of energy generators 313. Each energy generator 313 is arranged to align with a lattice space 256 in lattice-shaped support structure 255 such that the support structure 255 substantially aligns with supports 21 of the energy harvesting layer 110. The energy harvesting layer 110 may be laminated or adhered to the deformable layer 250. In an alternative embodiment, energy harvesting underlay 300B has a protective layer on top of the energy harvesting layer 110. The deformable layer 250 may be formed from rubber crumb, rubber and polyolefin and/or a plastics material with a blowing agent such as blown PVC. The support 255 may be formed from a resilient plastics or metal such as polycarbonate or aluminium.

A floor covering suitable for use with the energy generating underlay 300B according to the invention indicated generally at 300A is illustrated in Figure 11. Floor covering 300A is in the form of a tile and has a rigid decorative upper layer 140 and a lower layer 120 having a lower surface which is provided with studs or profiles 125. In use, the floor covering 300A is placed on the energy harvesting underlay 300B such that the studs or profiles 125 ensure maximum deflection of the energy harvesting layer 110 when a person walks on floor covering 300A by aligning each stud or profile 125 with an energy generator 113 of the energy harvesting layer 110.

In an alternative embodiment, the energy harvesting layer 110 may be replaced with an energy harvesting layer 10 according to the first embodiment of the invention. In such an embodiment, each stud or profile 125 is aligned with a dome-shaped energy generator 13. In an alternative embodiment, the floor covering 300A includes an intermediate scrim layer 110 between the decorative layer 140 and the lower layer 120. As an alternative embodiment, the flooring material 300 may have more than one energy harvesting layer 10,110.

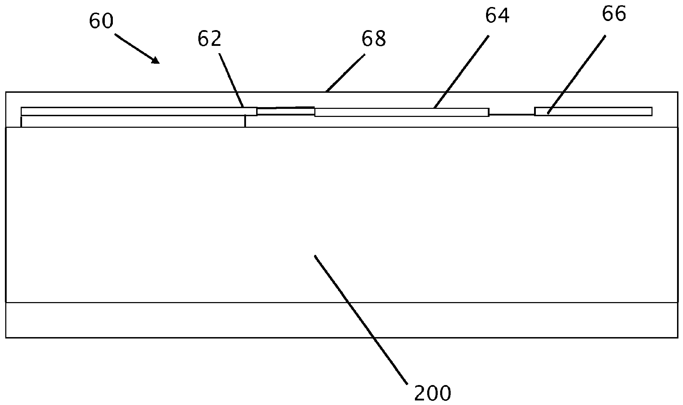

A first embodiment of an energy harvesting flooring system is indicated generally at 60 on Figure 12. The energy harvesting flooring system 60 comprises a synthetic flooring material 200 according to the first embodiment of the invention and an electrical housing 68 comprising electrical components 62,64,66.

The electrical components contained by electrical housing 68 include a power management system 62, electrical storage 64 and a lighting system 66. The power management system 62 is electrically connected to the energy harvesting layer 10 of the synthetic flooring material 200 to capture energy generated by the energy harvesting layer 10. The power management system 62 is connected to electrical storage 64 for storage of the electrical energy generated by energy harvesting layer 10. The stored electrical energy may be used in a number of different ways. In this embodiment, the electrical storage 64 is connected to an electrically powered device in the form of lighting system 66 for use of the stored electrical energy. In an alternative embodiment, the electrically powered device may be an alarm, a sensor and/or a display. In an alternative embodiment, the electrically powered device may be provided on a different surface such as a wall, door or ceiling.

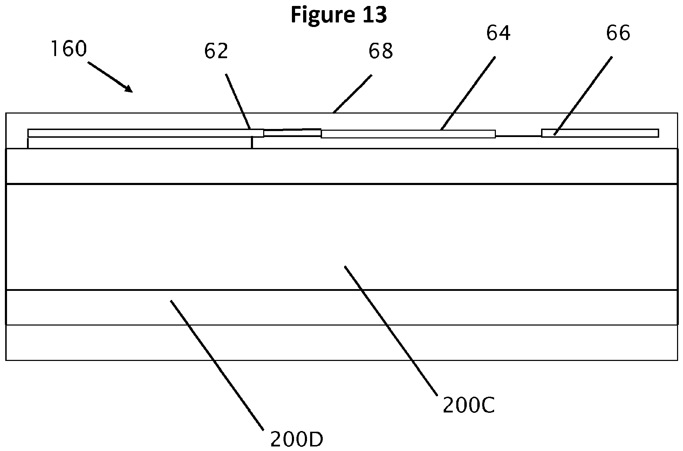

The second embodiment of an energy harvesting flooring system indicated generally at 160 is illustrated in Figure 13. The energy harvesting flooring system 160 comprises two types of synthetic flooring material 200C,200D and an electrical housing 68 comprising the electrical components 62,64,66. The synthetic flooring material 200C is a synthetic flooring material 200 according to a first embodiment of the invention as illustrated in Figure 9 where the energy harvesting layer 10 is as illustrated in Figure 7. Synthetic flooring material 200C is arranged in a high traffic area of the flooring system 560. The synthetic flooring material 200D is a synthetic flooring material 200 according to a first embodiment of the invention where the energy generators 13 have been replaced by a layer of synthetic material of similar thickness such that the upper and lower conductive layers 11,12 provide an electrical connection between synthetic flooring material 200C and electrical housing 68 and such that synthetic flooring material 200D has a similar thickness to synthetic flooring material 200C.

In an alternative embodiment, the synthetic flooring material 200C,200D may be provided as a single continuous synthetic flooring material having conducting areas where the energy generators 13 have been replaced by a layer of synthetic material of similar thickness and harvesting areas where the energy harvesting layer 10 is an energy harvesting layer as illustrated in Figure 7. In a further alternative embodiment, the synthetic flooring material may have one or more neutral areas where the energy harvesting layer 10 is a layer of plastics material having a similar thickness, for example in areas of low footfall where there is a low likelihood of energy harvesting.

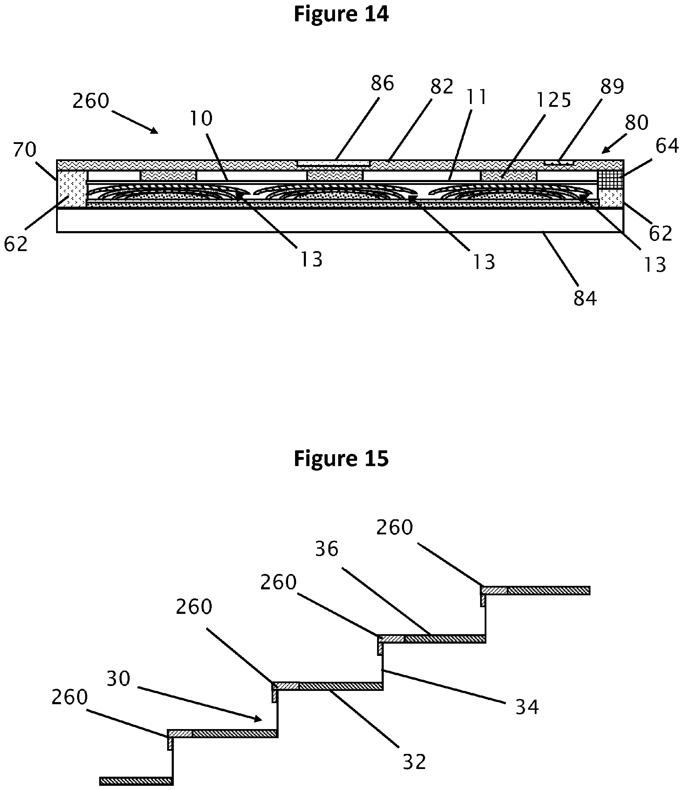

A third embodiment of an energy harvesting flooring system according to the invention indicated generally at 260 is illustrated in Figures 14 and 15. Energy harvesting flooring system 260 is in the form of a step nosing which is shown in use on Figure 15 mounted on a flight of stairs indicated generally at 30. The flight of stairs 30 comprises a series of horizontal treads 32 which increase in height from left to right and which are connected by a series of vertical risers 34. Each step nosing 260 is mounted at the front or left hand end of each tread 32, above each riser 34. Each tread 32 has a length of flooring 36 arranged between each nosing 260 and each riser 34. Flooring 36 has a height which is approximately the same as that of nosing 260 so that flooring 36 provides each tread 32 with a substantially horizontal surface upper surface. In an alternative embodiment, the lengths of flooring 36 may be omitted.

Step nosing 260 has a housing 70 and a cover indicated generally at 80. Cover 80 has an inverted L-shape with an upper horizontal part 82 which covers the housing 70 and a lower vertical part 84 which covers an upper part of the riser 34. Cover 80 has a light fitting 86 where the horizontal part 82 meets the vertical part 84 such that the light fitting 86 can provide illumination upwardly and downwardly. Cover 80 has a light sensor 89 in horizontal part 82. Cover 80 may be in the form of an extrusion and formed from a resilient extrudable material such as aluminium and may be provided with a non-slip coating such as a rubber profile or a grit coating such as is generally used in the art. In an alternative embodiment, the cover 80 may omit its vertical part 84.

Housing 70 of step nosing 260 contains an energy harvesting layer 10 according to a first embodiment of the invention comprising a plurality of energy generators 13 as illustrated in Figure 7, an energy storage system 64 and power management system 62. The power management system 62 has an electrical connection (not shown) to the light fitting 86 and light sensor 89. Housing 70 has an upper layer or cover which is formed by the upper horizontal part 82 of the cover 80. Horizontal part 82 of cover 80 has a lower surface which is provided with studs or profiles 125 which act as deflection aids. In an alternative embodiment, energy harvesting layer 10 may be replaced by an energy harvesting layer 110 according to the second embodiment of the invention which is illustrated in Figure 8. In an alternative embodiment, one or more of the energy generators 13 according to the first embodiment may be replaced by one or more energy generators 113 according to the second embodiment and/or one or more energy generators 213 according to the third embodiment and/or one or more energy generators 313 according to the fourth embodiment and/or one or more generators 413 according to the fifth embodiment and/or one or more generators 513 according to the sixth embodiment.

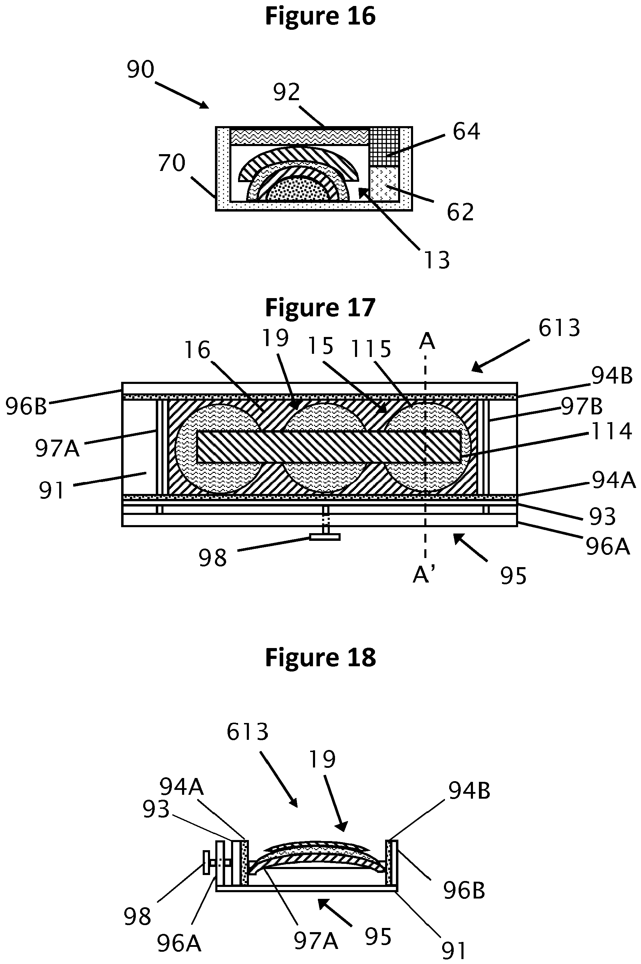

A first embodiment of an energy harvesting system according to the invention indicated generally at 90 is illustrated in Figure 16. Energy harvesting system 90 comprises a housing 70, an energy generator 13, a button 92, a power management system 62 and an energy storage system 64. Housing 70 contains and supports the energy generator 13, button 92, power management system 62 and energy storage system 64. Button 92 is arranged above the energy generator 13 such that it may receive kinetic energy and transmit it to the energy generator. The energy generator 13 is connected electrically to the power management system 62 and energy storage system 64. In an alternative embodiment, the energy harvesting system 90 may contain additional energy generators 13. In an alternative embodiment, the energy harvesting system 90 may include additional electrical components such as a light such as an LED, a communications device such as a wireless transmitter and/or a heating element. In an alternative embodiment, one or more of the energy generators 13 according to the first embodiment may be replaced by one or more energy generators 113 according to the second embodiment and/or one or more energy generators 213 according to the third embodiment and/or one or more energy generators 313 according to the fourth embodiment and/or one or more energy generators 413 according to the fifth embodiment and/or one or more energy generators 513 according to the sixth embodiment.

A seventh embodiment of a bistable energy generator is indicated generally at 613 on Figures 17 and 18. The cross-sectional view shown in Figure 18 is taken across line A-A' shown on Figure 17. Like features to the other embodiments of the bistable energy generator are identified by like reference numerals. Energy generator 613 includes a flexible energy harvesting material 19 and energy generator support 95.

Energy generator support 95 has outer walls 96A,96B, a base 91, a moveable clamp 93, a clamp control 98, and clamp rails 97A,97B. The flexible energy harvesting material 19 is arranged between moveable clamp 93 and outer wall 96B and between clamp rails 97A,97B. Outer wall 96B and moveable clamp 93 each have a strip of resilient material 94A,94B provided on their inner surfaces to engage the flexible energy harvesting material 19 such that the outer wall 96B and moveable clamp 93 grip the sides of the energy harvesting material 19. Moveable clamp 93 is slidingly mounted on rails 97A,97B such that rails 97A,97B control the orientation of the moveable clamp 93 for example such that clamp 93 does not rotate when it clamps the flexible energy harvesting material 19.

Clamp control 98 is in the form of a grub screw and extends through outer wall 96A to engage moveable clamp 93 to control the distance between moveable clamp 93 and outer wall 96A and the pressure applied by moveable clamp 93 to the energy harvesting material 19. In an alternate embodiment, the energy generator support 95 may have two or more clamp controls 98, depending upon the length of the support 95.

Flexible energy harvesting material 19 has three layers which comprise a flexible upper electrode 114, an energy harvesting material layer indicated at 15 and a resilient lower electrode 16 wherein the energy harvesting material layer 15 is arranged between the upper electrode 14 and the lower electrode 16.

Flexible upper electrode 114 is formed from a flexible conductive material such as a metal (e.g. brass, copper or aluminium), a conductive polymer, ink or a metal coated polymer. Lower electrode 16 is formed from a resilient conductive material such as a metal (e.g. brass, copper, nickel or aluminium) or a metal coated polymer. Energy harvesting material layer 15 comprises a sheet of insulating material on which are placed a plurality of circular energy harvesting material elements 115 arranged in a row such that the energy harvesting material 19 has an elongate shape. In an alternative embodiment, the plurality of circular energy harvesting material elements 115 can be placed in a differently shaped array on the sheet of insulating material of energy harvesting material layer 15 such that the energy harvesting material 19 has a different shape.

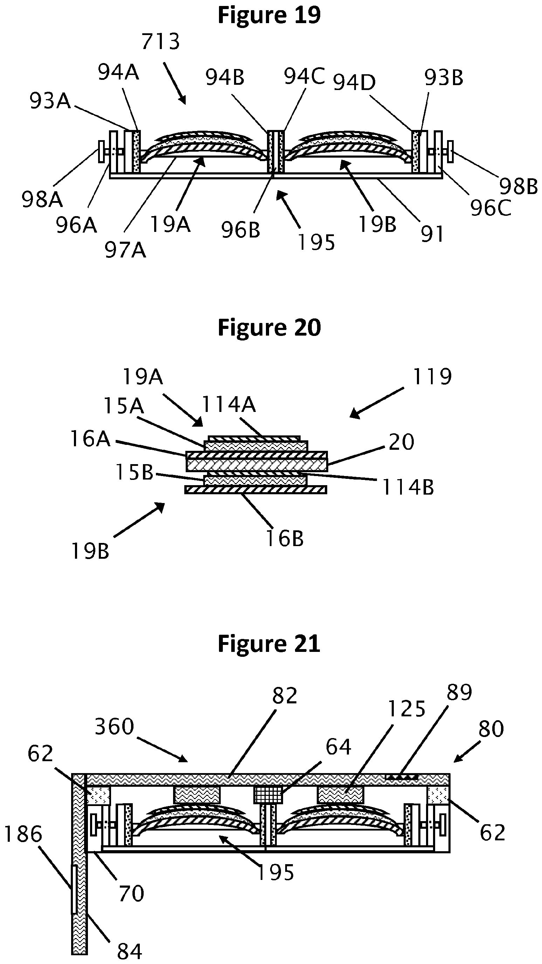

In an alternate embodiment, the energy harvesting material 19 may be replaced by the dual layer energy harvesting material as indicated generally at 119 on Figure 20. Dual layer energy harvesting material 119 comprises two layers of the energy harvesting material 19A,19B, separated by a separator layer 20 and stacked vertically.

As shown in Figure 18, when clamp control 98 is operated such that moveable clamp 93 engages the long edges of the strip shaped energy harvesting material 19,119, energy harvesting material 19,119 is urged into its clamped orientation such that energy generator 613 is in its first convex arch-shaped position.

Thus the energy harvesting material 19,119 may be induced into being a bistable energy generator by the application of pressure to its opposite sides by moveable clamp 93 as shown in Figure 18 such that the clamped energy harvesting material 19,119 has two stable orientations which are a first convex resting orientation and a second concave orientation. The clamped energy harvesting material 19,119 may be moved from its first orientation to their second orientation on the application of force but when the force is removed, the clamped energy harvesting material 19,119 deflects back to its first orientation because of the resilience of the material used to form the lower electrode 16 and the asymmetric profile of the structure of the energy harvesting material 19,119. The energy harvesting material 19,119 is asymmetric because the active piezoelectric material has a different shape and mechanical properties from the rigid support material. This makes it more difficult to bend the structure downwards than upwards, making the convex shape a state of lower potential energy, and thus a state of rest. Thus, the bistable lower electrode 16 is a deflection aid. Accordingly, the bistable lower electrode 16 resiliently biases the clamped energy harvesting material 19,119 into a first convex arch-shaped position as depicted in Figure 18.

An eighth embodiment of a bistable energy generator is indicated generally at 713 on Figure 19. Like features to the other embodiments of the bistable energy generator are identified by like reference numerals. Energy generator 713 includes energy harvesting material 19A,19B and a dual energy generator support 195.

Dual energy generator support 195 has outer walls 96A,96C, inner wall 96B, a base 91, two moveable clamps 93A,93B, two clamp controls 98, and clamp rails 97A,97B. Energy harvesting material 19A is arranged between moveable clamp 93A and inner wall 96B and between clamp rails 97A,97B. Energy harvesting material 19B is arranged between moveable clamp 93B and inner wall 96B and between clamp rails 97A,97B. On each side of inner wall 96B and on the inner sides of moveable clamps 93A,93B a strip of resilient material 94A,94B,94C,94D is provided to engage the energy harvesting material 19A,19B such that the inner wall 96B and moveable clamps 93A,93B grip the sides of the energy harvesting material 19A,19B. Moveable clamps 93A,93B are slidingly mounted on rails 97A,97B such that rails 97A,97B control the orientation of the moveable clamps 93A,93B for example such that each clamp 93A,93B does not rotate when it clamps the energy harvesting material 19A,19B.

Clamp controls 98A,98B are in the form of grub screws. Clamp control 98A extends through outer wall 96A to engage moveable clamp 93A to control the distance between moveable clamp 93A and inner wall 96B and the pressure applied by moveable clamp 93A to the energy harvesting material 19A. Clamp control 98B extends through outer wall 96C to engage moveable clamp 93B to control the distance between moveable clamp 93B and inner wall 96B and the pressure applied by moveable clamp 93B to the energy harvesting material 19B. In an alternate embodiment, the energy generator support 95 may have additional clamp controls 98A,98B, depending upon the length of the support 195.

In an alternate embodiment, energy harvesting material 19A,19B may be replaced by dual layered energy harvesting material 119.

A fourth embodiment of an energy harvesting flooring system according to the invention indicated generally at 360 is illustrated in Figure 21. Energy harvesting flooring system 360 is in the form of a step nosing.

Step nosing 360 has a housing 70 and a cover indicated generally at 80. Cover 80 has a rotated L-shape with an upper horizontal part 82 which covers the housing 70 and a lower vertical part 84 which covers an upper part of a riser 34. Cover 80 has a light fitting 186 on the vertical part 84. Light fitting 186 has a lens to diffuse light across the width of its step. Cover 80 has a light sensor 89 in horizontal part 82. Cover 80 may be in the form of an extrusion and is formed from a resilient extrudable material such as aluminium and may be provided with a non-slip coating such as a rubber profile or a grit coating such as is generally used in the art.

Housing 70 of step nosing 360 contains an eighth embodiment of a bistable energy generator 713 as illustrated in Figure 19, an energy storage system 64 and power management system 62. The power management system 62 has an electrical connection (not shown) to the light fitting 86 and light sensor 89. Housing 70 has an upper layer or cover which is formed by the upper horizontal part 82 of the cover 80. Horizontal part 82 of cover 80 has a lower surface which is provided with studs or profiles 125 which act as deflection aids. Cover 80 is removable such that the clamp controls 98A,98B may be accessed such that they can be adjusted so that the bistable energy generator 713 may be maintained. In an alternative embodiment, bistable energy generator 713 may be replaced by a bistable energy generator 613 or by an energy harvesting layer 10 according to a first embodiment of the invention, an energy harvesting layer 110 according to the second embodiment of the invention.

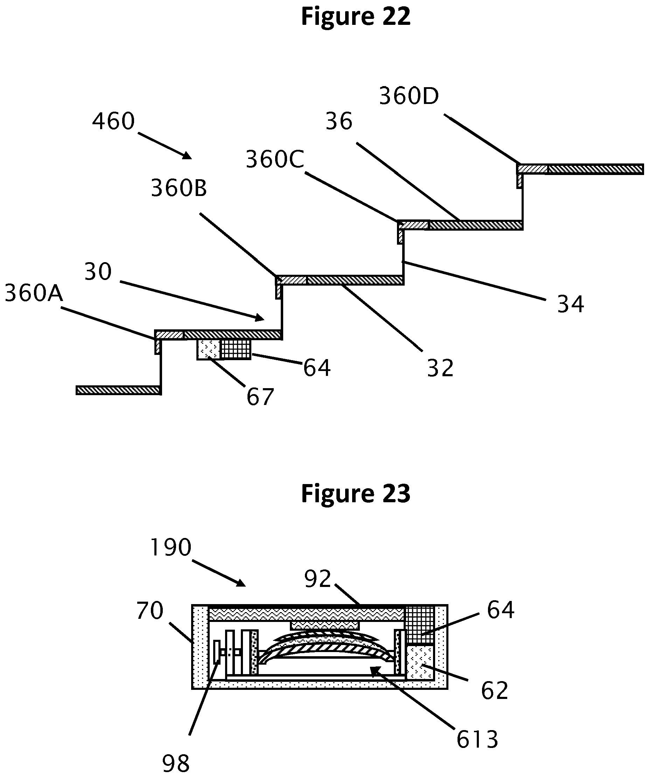

A fifth embodiment of an energy harvesting flooring system according to the invention indicated generally at 460 is illustrated in Figure 22. Energy harvesting flooring system 460 comprises a plurality of step nosings 360 which are shown in use on Figure 23 mounted on a flight of stairs indicated generally at 30. The flight of stairs 30 comprises a series of horizontal treads 32 which increase in height from left to right and which are connected by a series of vertical risers 34. Each step nosing 360 is mounted at the front or left-hand end of each tread 32, above each riser 34. Each tread 32 has a length of flooring 36 arranged between each nosing 260 and each riser 34. Flooring 36 has a height which is approximately the same as that of nosing 260 so that flooring 36 provides each tread 32 with a substantially horizontal surface upper surface. In an alternative embodiment, the lengths of flooring 36 may be omitted.

System 460 has a control module 67 and an energy storage 64. Control module 67 is operably connected to each of the stair nosings 360 to detect inputs from the step nosings 360, to control storage of electrical energy in storage 64 and to control illumination by the light fittings 86. Inputs from the stair nosings 360 which are detected by the control module 67 include operation of the energy generator 613 by a user (not shown) stepping on the stair nosing and operation of the light sensor 89 to detect whether the level of ambient light is sufficiently low to require illumination by light fittings 186. The system is programmed such that when the presence of a user on the uppermost step nosing 360D is detected, a light 86,186 on the next lower step is activated to illuminate that step and/or when the presence of a user on the lowermost step nosing 360A is detected, a light 86,186 on the next upper step is activated to illuminate that step such that the steps are illuminated in the direction of travel of the user; in other words, the user can see where he/she is going. In an alternative embodiment, one or more steps in the direction of travel may be illuminated.

A second embodiment of an energy harvesting system according to the invention indicated generally at 190 is illustrated in Figure 23. Energy harvesting system 190 comprises a housing 70, a bistable energy generator 613, a button 92, a power management system 62 and an energy storage system 64. Housing 70 contains and supports the bistable energy generator 613, button 92, power management system 62 and energy storage system 64. Housing 70 may be opened to allow maintenance of the bistable energy generator 613 for example by adjustment of the clamp control 98. Button 92 is arranged above the energy generator 13 such that it may receive kinetic energy and transmit it to the energy generator 613. The energy generator 613 is connected electrically to the power management system 62 and energy storage system 64. In an alternative embodiment, the energy harvesting system 90 may contain additional energy generators 613. In an alternative embodiment, the energy harvesting system 90 may include additional electrical components such as a light such as an LED, a communications device such as a wireless transmitter and/or a heating element. In an alternative embodiment, one or more of the energy generators 613 may be replaced by one or more energy generators 713.

## Claims

1. An energy generator comprising an energy harvesting material which generates energy when moved from a pre-selected first position to a second position wherein the energy generator comprises one or more deflection aids which comprise a moveable clamp wherein each deflection aid biases the energy harvesting material to the first position and wherein the first position of the energy harvesting material is pre-selected using the moveable clamp.

2. An energy generator as defined in Claim 1 which comprises a buffer deflection aid to deflect the energy harvesting material to its first position; preferably the buffer deflection aid may be formed from a resilient material.

3. An energy generator as defined in Claim 1 or Claim 2 which comprises a bistable deflection aid; preferably the bistable deflection aid comprises a sprung or pressed element; preferably the bistable deflection aid functions as an electrode.

4. An energy generator as defined in Claim 1 wherein the deflection aid comprises an energy generator support which comprises the moveable clamp and a support wall between which the energy harvesting material may be clamped in the first position.

5. An energy generator as defined in any one of the preceding Claims wherein the energy harvesting material is a flexible energy harvesting material comprising a flexible upper electrode, a layer of piezoelectric material and a resilient lower electrode wherein the layer of piezoelectric material is arranged between the upper and lower electrodes; preferably the resilient lower electrode may be in the form of a rigid conductive support.

6. An energy generator as defined in any one of the preceding Claims wherein the energy generator support has one or more clamp rails to guide the movement of the moveable clamp.

7. An energy generator as defined in any one of the preceding Claims wherein the energy generator support has a clamp control to control the movement of the moveable clamp such that the deflection aid is an adjustable deflection aid.

8. An energy generator as defined in any one of Claims 4 to 7 wherein the moveable clamp and support wall of the energy generator support have resilient material on their inner surfaces to engage the energy harvesting material.

9. An energy generator as defined in any one of the preceding Claims which comprises at least one electrode; preferably the energy generator comprises an upper electrode and a lower electrode which are respectively arranged above and below the energy harvesting material.

10. An energy harvesting floor covering comprising a layer of synthetic material and an energy harvesting layer which comprises one or more energy generators as defined in any one of the preceding claims.

11. A floor covering as defined in Claim 10 which comprises a deflection aid; preferably the deflection aid comprises one or more studs on a lower surface of the layer of synthetic material

12. A flooring material as defined in Claim 10 or Claim 11 wherein the flooring material is in the form of underlay for placing under conventional flooring material.

13. A flooring material as defined in any one of Claims 10 to 12 wherein the flooring material comprises a support structure.

14. An energy harvesting system comprising a power management circuit, an electrical storage device and at least one energy generator as defined in any one of Claims 1 to 9.

15. An energy harvesting system as defined in Claim 14 which comprises an electrically powered device; preferably the electrically powered device is a light, communication device, a sensor, and/or an alarm; preferably the sensor is a light sensor and/or a presence sensor.

16. An energy harvesting system as defined in Claim 14 or Claim 15 which is in the form of a step nosing for placing on a step; preferably the system comprises a plurality of step nosings for mounting on a flight of steps, a control module and an energy storage wherein the step nosings are operably connected to the control module and energy storage; preferably the control module is programmed to illuminate the flight of steps in the direction of travel by a user.
